# EUROPEAN PATENT APPLICATION

(11) **EP 4 779 622 A1**
(43) Date of publication of application: **22.07.2026**
(21) Application number: 25225809.0
(22) Date of filing: 19.12.2025
(51) Int. Cl.: G09G 3/32

(54) **PIXEL, DISPLAY DEVICE INCLUDING THE SAME, AND ELECTRONIC APPARATUS INCLUDING THE SAME**

(30) Priority: 21.01.2025 KR 20250008449
(71) Applicant: Samsung Display Co., Ltd., Yongin-si, Gyeonggi-do 17113 (KR)
(72) Inventor: KIM, Kwihyun, 17113 Yongin-si (KR); KIM, Ji-Sun, 17113 Yongin-si (KR); LEE, Sunhwa, 17113 Yongin-si (KR); LEE, Sehyun, 17113 Yongin-si (KR); CHUNG, Kyunghoon, 17113 Yongin-si (KR)
(74) Representative: Walaski, Jan Filip

(57) **Abstract**

A pixel includes a first sub-pixel including a first light-emitting element connected between a high voltage power supply line to transmit a high power supply voltage and a first low voltage power supply line to transmit a first low power supply voltage lower than the high power supply voltage, and a second sub-pixel including a second light-emitting element connected between the high voltage power supply line and a second low voltage power supply line to transmit a second low power supply voltage lower than the high power supply voltage. The first low power supply voltage is higher than the second low power supply voltage.

## Description

### BACKGROUND

### 1. Field

The disclosure relates to a display device. More particularly, the disclosure relates to a pixel including sub-pixels, a display device including the pixel, and an electronic apparatus including the display device.

### 2. Description of the Related Art

A display device may include a display panel and a panel driver. The display panel may include pixels. The panel driver may provide gate signals, a data voltage, etc. to each of the pixels. The pixel may include sub-pixels. The sub-pixels may display different colors, and the pixel may display one color formed by different colors.

The sub-pixel may include a light-emitting element connected between a high voltage power supply line transmitting a high voltage and a low voltage power supply line transmitting a low voltage. Power consumption of the sub-pixel may correspond to a product of a voltage difference between the high power supply voltage and the low power supply voltage and a current flowing through the light-emitting element.

### SUMMARY

Embodiments provide a pixel with reduced power consumption, a display device including the pixel, and an electronic apparatus including the display device.

A pixel according to embodiments includes a first sub-pixel including a first light-emitting element connected between a high voltage power supply line to transmit a high power supply voltage and a first low voltage power supply line to transmit a first low power supply voltage lower than the high power supply voltage, and a second sub-pixel including a second light-emitting element connected between the high voltage power supply line and a second low voltage power supply line to transmit a second low power supply voltage lower than the high power supply voltage. The first low power supply voltage is higher than the second low power supply voltage.

In an embodiment, the pixel may further include a third sub-pixel including a third light-emitting element connected between the high voltage power supply line and the second low voltage power supply line.

In an embodiment, the first light-emitting element may emit red light, the second light-emitting element may emit green light, and the third light-emitting element may emit blue light.

In an embodiment, a turn-on voltage of the first light-emitting element may be lower than a turn-on voltage of the second light-emitting element. The turn-on voltage of the second light-emitting element may be lower than a turn-on voltage of the third light-emitting element.

In an embodiment, a first cathode electrode connected to a second electrode of the first light-emitting element and a second cathode electrode connected to both a second electrode of the second light-emitting element and a second electrode of the third light-emitting element may extend in a first direction. The first low voltage power supply line connected to the first cathode electrode and the second low voltage power supply line connected to the second cathode electrode may extend in a second direction intersecting the first direction.

In an embodiment, the pixel may further include a third sub-pixel including a third light-emitting element connected between the high voltage power supply line and a third low voltage power supply line to transmit a third low power supply voltage lower than the high power supply voltage. The second low power supply voltage may be higher than the third low power supply voltage.

In an embodiment, a first cathode electrode connected to a second electrode of the first light-emitting element, a second cathode electrode connected to a second electrode of the second light-emitting element, and a third cathode electrode connected a second electrode of the third light-emitting element may extend in a first direction. The first low voltage power supply line connected to the first cathode electrode, the second low voltage power supply line connected to the second cathode electrode, and the third low voltage power supply line connected to the third cathode electrode may extend in a second direction intersecting the first direction.

In an embodiment, a voltage difference between the first low power supply voltage and the second low power supply voltage may be greater than or equal to 0.1 voltages (V) and less than or equal to 2.0V.

In an embodiment, each of the first light-emitting element and the second light-emitting element may be a micro light-emitting diode.

In an embodiment, each of the first sub-pixel and the second sub-pixel may further include a first transistor including a gate connected to a first node, a first terminal connected to a second node, and a second terminal connected to a third node, a second transistor to transmit a data voltage to the second node in response to a first gate signal, a third transistor to connect the first node to the third node in response to a second gate signal, a fourth transistor to transmit a first initialization voltage to the first node in response to a third gate signal, a fifth transistor to transmit the high power supply voltage to the second node in response to an emission signal, a sixth transistor to connect the third node to a fourth node connected to a first electrode of a corresponding light-emitting element among the first light-emitting element and the second light-emitting element in response to the emission signal, a seventh transistor to transmit a second initialization voltage to the fourth node in response to a fourth gate signal, and a first capacitor connected between the high voltage power supply line and the first node.

In an embodiment, each of the first sub-pixel and the second sub-pixel may further include an eight transistor to transmit a bias voltage to the second node in response to the fourth gate signal.

In an embodiment, each of the first sub-pixel and the second sub-pixel may further include a second capacitor connected between a gate line to transmit the first gate signal and the first node.

In an embodiment, a voltage level of the first low power supply voltage in a low brightness mode may be higher than a voltage level of the first low power supply voltage in a medium brightness mode having a luminance level higher than a luminance level of the low luminance mode. A voltage level of the second low power supply voltage in the low brightness mode may be higher than a voltage level of the second low power supply voltage in the medium brightness mode.

In an embodiment, a voltage level of the first low power supply voltage in a high brightness mode having a luminance level higher than the luminance level of the medium luminance mode may be lower than the voltage level of the first low power supply voltage in the medium brightness mode. A voltage level of the second low power supply voltage in the high brightness mode may be lower than the voltage level of the second low power supply voltage in the medium brightness mode.

A display device according to embodiments includes a display panel including a pixel, and a panel driver to provide a high power supply voltage, a first low power supply voltage lower than the high power supply voltage, and a second low power supply voltage lower than the high power supply voltage. The pixel includes a first sub-pixel including a first light-emitting element connected between a high voltage power supply line to transmit the high power supply voltage and a first low voltage power supply line to transmit the first low power supply voltage, and a second sub-pixel including a second light-emitting element connected between the high voltage power supply line and a second low voltage power supply line to transmit the second low power supply voltage. The first low power supply voltage is higher than the second low power supply voltage.

In an embodiment, the pixel may further include a third sub-pixel including a third light-emitting element connected between the high voltage power supply line and the second low voltage power supply line.

In an embodiment, the first light-emitting element may emit red light, the second light-emitting element may emit green light, and the third light-emitting element may emit blue light.

In an embodiment, a turn-on voltage of the first light-emitting element may be lower than a turn-on voltage of the second light-emitting element. The turn-on voltage of the second light-emitting element may be lower than a turn-on voltage of the third light-emitting element.

In an embodiment, the pixel may further include a third sub-pixel including a third light-emitting element connected between the high voltage power supply line and a third low voltage power supply line to transmit a third low power supply voltage lower than the high power supply voltage. The second low power supply voltage may be higher than the third low power supply voltage.

An electronic apparatus according to embodiments includes a display device, and a processor to control the display device. The display device includes a display panel including a pixel, and a panel driver to provide a high power supply voltage, a first low power supply voltage lower than the high power supply voltage, and a second low power supply voltage lower than the high power supply voltage. The pixel includes a first sub-pixel including a first light-emitting element connected between a high voltage power supply line to transmit the high power supply voltage and a first low voltage power supply line to transmit the first low power supply voltage, and a second sub-pixel including a second light-emitting element connected between the high voltage power supply line and a second low voltage power supply line to transmit the second low power supply voltage. The first low power supply voltage is higher than the second low power supply voltage.

In the pixel, the display device, and the electronic apparatus according to the embodiments, the low power supply voltages having different voltage levels are applied to the sub-pixels included in the pixel, so that the power consumption of the pixel may be effectively reduced. Accordingly, power consumption of the display device including the pixel may be effectively reduced, and power consumption of the electronic apparatus may be effectively reduced.

### BRIEF DESCRIPTION OF THE DRAWINGS

Illustrative, non-limiting embodiments will be more clearly understood from the following detailed description taken in conjunction with the accompanying drawings.
FIG. 1 is a block diagram illustrating a display device according to an embodiment.
FIG. 2 is a circuit diagram illustrating a pixel of FIG. 1.
FIG. 3 is a graph illustrating relationships between voltages and currents of light-emitting elements of FIG. 2.
FIG. 4 is a diagram for describing voltages of sub-pixels of FIG. 2.
FIG. 5 is a plan view illustrating the pixel of FIG. 2.
FIG. 6 is a cross-sectional view taken along a line I-I', a line II-II', and a line III-III' of FIG. 5.
FIG. 7 is a block diagram illustrating a display device according to an embodiment.
FIG. 8 is a circuit diagram illustrating a pixel of FIG. 7.
FIG. 9 is a diagram for describing voltages of sub-pixels of FIG. 8.
FIG. 10 is a plan view illustrating the pixel of FIG. 8.
FIG. 11 is a cross-sectional view taken along a line IV-IV', a line V-V', and a line VI-VI' of FIG. 10.
FIG. 12 is a table illustrating first to third low power supply voltages in brightness modes.
FIG. 13 is a block diagram illustrating an electronic apparatus according to an embodiment.
FIG. 14 is a diagram illustrating an example in which the electronic apparatus of FIG. 13 is implemented as a smart watch.

### DETAILED DESCRIPTION

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

"About" or "substantially equal" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "substantially equal" can mean within one or more standard deviations, or within ± 10%, 5% or 2% of the stated value.

Hereinafter, a pixel, a display device, and an electronic apparatus according to embodiments of the present disclosure will be described in more detail with reference to the accompanying drawings. The same or similar reference numerals will be used for the same elements in the accompanying drawings.

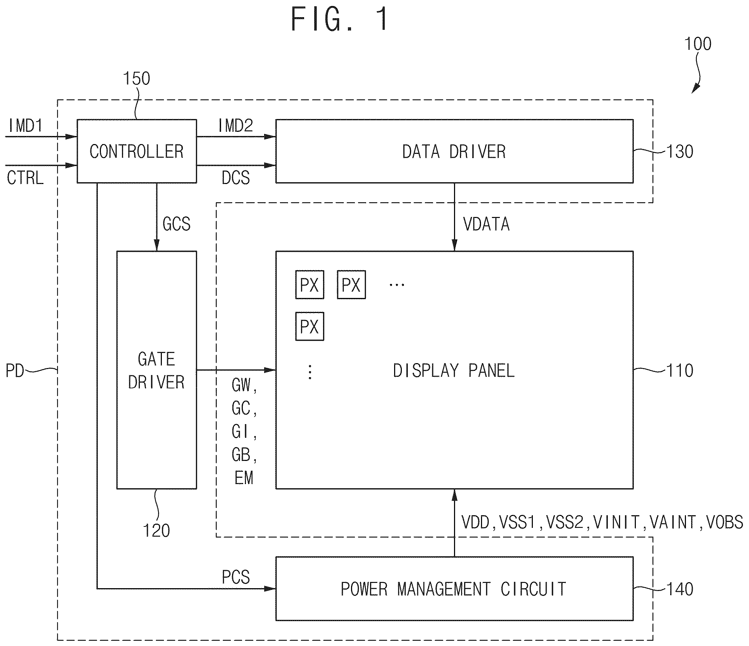

FIG. 1 is a block diagram illustrating a display device 100 according to an embodiment.

Referring to FIG. 1, the display device 100 may include a display panel 110 and a panel driver PD. The panel driver PD may include a gate driver 120, a data driver 130, a power management circuit 140, and a controller 150.

The display panel 110 may include a plurality of pixels PX. Each of the pixels PX may include a plurality of sub-pixels. The sub-pixels may display different colors. Each of the pixels PX may display one color composed of different colors displayed in the sub-pixels.

The gate driver 120 may provide a first gate signal GW, a second gate signal GC, a third gate signal GI, a fourth gate signal GB, and an emission signal EM to each of the pixels PX. The gate driver 120 may generate the first gate signal GW, the second gate signal GC, the third gate signal GI, the fourth gate signal GB, and the emission signal EM based on a gate control signal GCS. The gate control signal GCS may include a gate clock signal, a gate start signal, etc.

The data driver 130 may provide a data voltage VDATA to each of the pixels PX. The data driver 130 may generate the data voltage VDATA based on output image data IMD2 and a data control signal DCS. The data driver 130 may convert the output image data IMD2 in a digital form into the data voltage VDATA in an analog form. The data control signal DCS may include a data clock signal, a load signal, an output data enable signal, etc.

The power management circuit 140 may provide a high power supply voltage VDD ("power supply voltage" is also referred to as a supply voltage or a power voltage), a first low power supply voltage VSS1, a second low power supply voltage VSS2, a first initialization voltage VINIT, a second initialization voltage VAINT, and a bias voltage VOBS to the pixels PX. The power management circuit 140 may generate the high power supply voltage VDD, the first low power supply voltage VSS1, the second low power supply voltage VSS2, the first initialization voltage VINIT, the second initialization voltage VAINT, and the bias voltage VOBS based on a power control signal PCS.

The controller 150 may control the gate driver 120, the data driver 130, and the power management circuit 140. The controller 150 may provide the gate control signal GCS to the gate driver 120, may provide the output image data IMD2 and the data control signal DCS to the data driver 130, and may provide the power control signal PCS to the power management circuit 140. The controller 150 may convert input image data IMD1 into the output image data IMD2. The controller 150 may generate the gate control signal GCS, the data control signal DCS, and the power control signal PCS based on a control signal CTRL. The control signal CTRL may include a vertical synchronization signal, a horizontal synchronization signal, a master clock signal, an input data enable signal, etc.

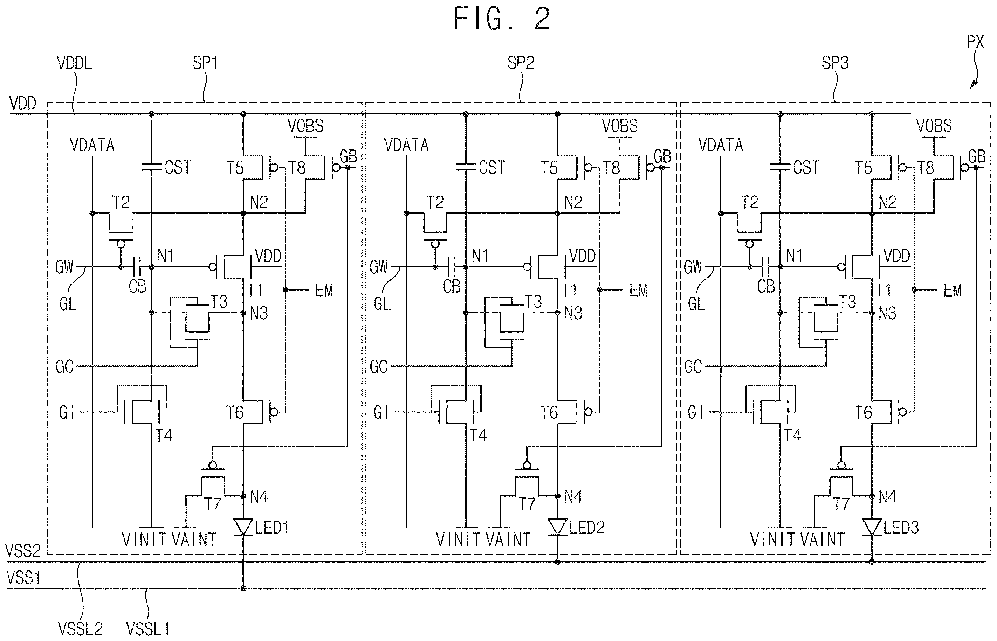

FIG. 2 is a circuit diagram illustrating the pixel PX of FIG. 1.

Referring to FIGS. 1 and 2, the pixel PX may include a first sub-pixel SP1, a second sub-pixel SP2, and a third sub-pixel SP3.

The first sub-pixel SP1 may include a first light-emitting element LED1. The first light-emitting element LED1 may be connected between a high voltage power supply line VDDL that transmits the high power supply voltage VDD and a first low voltage power supply line VSSL1 that transmits the first low power supply voltage VSS1. The first light-emitting element LED1 may include a first terminal connected to a fourth node N4 of the first sub-pixel SP1 and a second terminal connected to the first low voltage power supply line VSSL1. The first low power supply voltage VSS1 may be lower than the high power supply voltage VDD. For example, the high power supply voltage VDD may be about 4.6 V.

The second sub-pixel SP2 may include a second light-emitting element LED2. The second light-emitting element LED2 may be connected between the high voltage power supply line VDDL and a second low voltage power supply line VSSL2 that transmits the second low power supply voltage VSS2. The second light-emitting element LED2 may include a first terminal connected to a fourth node N4 of the second sub-pixel SP2 and a second terminal connected to the second low voltage power supply line VSSL2. The first low power supply voltage VSS1 may be higher than the second low power supply voltage VSS2. For example, the first low power supply voltage VSS1 may be about 0.5 V, and the second low power supply voltage VSS2 may be about 0 V.

The third sub-pixel SP3 may include a third light-emitting element LED3. The third light-emitting element LED3 may be connected between the high voltage power supply line VDDL and the second low voltage power supply line VSSL2. The third light-emitting element LED3 may include a first terminal connected to a fourth node N4 of the third sub-pixel SP3 and a second terminal connected to the second low voltage power supply line VSSL2.

In an embodiment, the first light-emitting element LED1 may emit red light, the second light-emitting element LED2 may emit green light, and the third light-emitting element LED3 may emit blue light. In this case, the first sub-pixel SP1, the second sub-pixel SP2, and the third sub-pixel SP3 may be a red sub-pixel, a green sub-pixel, and a blue sub-pixel, respectively.

In an embodiment, each of the first light-emitting element LED1, the second light-emitting element LED2, and the third light-emitting element LED3 may be a micro light-emitting diode (µLED).

Each of the first sub-pixel SP1, the second sub-pixel SP2, and the third sub-pixel SP3 may further include a first transistor T1, a second transistor T2, a third transistor T3, a fourth transistor T4, a fifth transistor T5, a sixth transistor T6, a seventh transistor T7, and a first capacitor CST. In an embodiment, each of the first sub-pixel SP1, the second sub-pixel SP2, and the third sub-pixel SP3 may further include an eighth transistor T8. In an embodiment, each of the first sub-pixel SP1, the second sub-pixel SP2, and the third sub-pixel SP3 may further include a second capacitor CB.

The first transistor T1 may include a gate connected to a first node N1, a first terminal connected to a second node N2, and a second terminal connected to a third node N3. The first transistor T1 may generate a driving current corresponding to a voltage difference between the first node N1 and the second node N2. In an embodiment, the first transistor T1 may further include a back gate or body that receives the high power supply voltage VDD.

The second transistor T2 may transmit the data voltage VDATA to the second node N2 in response to the first gate signal GW. The second transistor T2 may include a gate that receives the first gate signal GW, a first terminal that receives the data voltage VDATA, and a second terminal connected to the second node N2.

The third transistor T3 may connect the first node N1 to the third node N3 in response to the second gate signal GC. The third transistor T3 may include a gate that receives the second gate signal GC, a first terminal connected to the third node N3, and a second terminal connected to the first node N1. In an embodiment, the third transistor T3 may further include a back gate or body that receives the second gate signal GC.

The fourth transistor T4 may transmit the first initialization voltage VINIT to the first node N1 in response to the third gate signal GI. The fourth transistor T4 may include a gate that receives the third gate signal GI, a first terminal that receives the first initialization voltage VINIT, and a second terminal connected to the first node N1. In an embodiment, the fourth transistor T4 may further include a back gate or body that receives the third gate signal GI.

The fifth transistor T5 may transmit the high power supply voltage VDD to the second node N2 in response to the emission signal EM. The fifth transistor T5 may include a gate that receives the emission signal EM, a first terminal that receives the high power supply voltage VDD, and a second terminal connected to the second node N2.

The sixth transistor T6 may connect the third node N3 to the fourth node N4 in response to the emission signal EM. The sixth transistor T6 may include a gate that receives the emission signal EM, a first terminal connected to the third node N3, and a second terminal connected to the fourth node N4.

The seventh transistor T7 may transmit the second initialization voltage VAINT to the fourth node N4 in response to the fourth gate signal GB. The seventh transistor T7 may include a gate that receives the fourth gate signal GB, a first terminal that receives the second initialization voltage VAINT, and a second terminal connected to the fourth node N4.

The eighth transistor T8 may transmit the bias voltage VOBS to the second node N2 in response to the fourth gate signal GB. The eighth transistor T8 may include a gate that receives the fourth gate signal GB, a first terminal that receives the bias voltage VOBS, and a second terminal connected to the second node N2.

In an embodiment, each of the first transistor T1, the second transistor T2, the fifth transistor T5, the sixth transistor T6, the seventh transistor T7, and the eighth transistor T8 may be a P-type transistor (e.g., a PMOS transistor), and each of the third transistor T3 and the fourth transistor T4 may be an N-type transistor (e.g., an NMOS transistor).

The first capacitor CST may be connected between the high voltage power supply line VDDL and the first node N1. The first capacitor CST may include a first terminal connected to the high voltage power supply line VDDL and a second terminal connected to the first node N1. The first capacitor CST may store a voltage of the first node N1.

The second capacitor CB may be connected between a gate line GL that transmits the first gate signal GW and the first node N1. The second capacitor CB may include a first terminal connected to the gate line GL and a second terminal connected to the first node N1. The second capacitor CB may boost the voltage of the first node N1 in response to a change in the first gate signal GW.

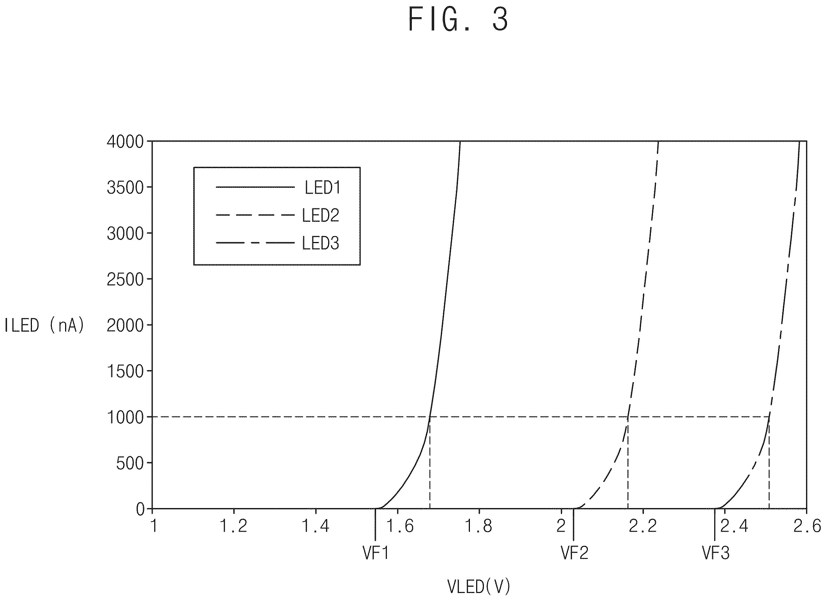

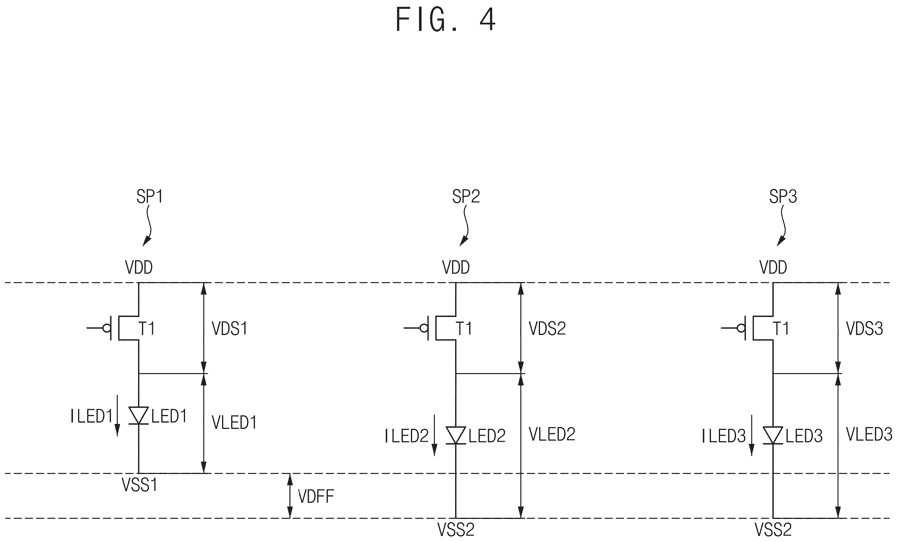

FIG. 3 is a graph illustrating relationships between voltages VLED (VLED1, VLED2, and VLED3 in FIG. 4) and currents ILED (ILED1, ILED2, and ILED3 in FIG. 4) of the light-emitting elements LED1, LED2, and LED3 of FIG. 2. FIG. 4 is a diagram for describing voltages VLED1, VLED2, and VLED3 of the sub-pixels SP1, SP2, and SP3 of FIG. 2.

Referring to FIGS. 2, 3, and 4, a turn-on voltage VF1 of the first light-emitting element LED1, a turn-on voltage VF2 of the second light-emitting element LED2, and a turn-on voltage VF3 of the third light-emitting element LED3 may be different from each other. The turn-on voltage may be a voltage at which the driving current starts to flow to the light-emitting element. The first light-emitting element LED1, the second light-emitting element LED2, and the third light-emitting element LED3 that emit different colors may include different materials, and thus, the turn-on voltage VF1 of the first light-emitting element LED1, the turn-on voltage VF2 of the second light-emitting element LED2, and the turn-on voltage VF3 of the third light-emitting element LED3 may be different from each other.

In an embodiment, the turn-on voltage VF1 of the first light-emitting element LED1 may be lower than the turn-on voltage VF2 of the second light-emitting element LED2, and the turn-on voltage VF2 of the second light-emitting element LED2 may be lower than the turn-on voltage VF3 of the third light-emitting element LED3. For example, the turn-on voltage VF1 of the first light-emitting element LED1 may be about 1.5 V, the turn-on voltage VF2 of the second light-emitting element LED2 may be about 2.0 V, and the turn-on voltage VF3 of the third light-emitting element LED3 may be about 2.35 V.

Since the turn-on voltage VF1 of the first light-emitting element LED1, the turn-on voltage VF2 of the second light-emitting element LED2, and the turn-on voltage VF3 of the third light-emitting element LED3 are different from each other, when the same driving current flows through the first light-emitting element LED1, the second light-emitting element LED2, and the third light-emitting element LED3, a driving voltage VLED1 of the first light-emitting element LED1, a driving voltage VLED2 of the second light-emitting element LED2, and a driving voltage VLED3 of the third light-emitting element LED3 may be different from each other. For example, when a driving current of 1000 nanoamperes (nA) flows through the first light-emitting element LED1, the second light-emitting element LED2, and the third light-emitting element LED3, the driving voltage VLED1 of the first light-emitting element LED1 may be lower than the driving voltage VLED2 of the second light-emitting element LED2, and the driving voltage VLED2 of the second light-emitting element LED2 may be lower than the driving voltage VLED3 of the third light-emitting element LED3.

When the first transistor T1 is turned on and the driving current ILED flows from the high voltage power supply line VDDL to the low voltage power supply line, a voltage between the first terminal and the second terminal of the fifth transistor T5 and a voltage between the first terminal and the second terminal of the sixth transistor T6 may be ignored, so that a sum of a voltage between the first terminal and the second terminal of the first transistor T1 (i.e., a drain-source voltage VDS) and a voltage between the first terminal and the second terminal of the light-emitting element (i.e., the driving voltage VLED) may be substantially equal to a value obtained by subtracting the low power supply voltage from the high power supply voltage VDD.

In a comparative example, the second terminal of the first light-emitting element LED1, the second terminal of the second light-emitting element LED2, and the second terminal of the third light-emitting element LED3 may all be connected to the second low voltage power supply line VSSL2, and thus, the second terminal of the first light-emitting element LED1, the second terminal of the second light-emitting element LED2, and the second terminal of the third light-emitting element LED3 may all receive the second low power supply voltage VSS2. In the comparative example, a sum of the drain-source voltage VDS1 of the first transistor T1 of the first sub-pixel SP1 and the driving voltage VLED1 of the first light-emitting element LED1, a sum of the drain-source voltage VDS2 of the first transistor T1 of the second sub-pixel SP2 and the driving voltage VLED2 of the second light-emitting element LED2, and a sum of the drain-source voltage VDS3 of the first transistor T1 of the third sub-pixel SP3 and the driving voltage VLED3 of the third light-emitting element LED3 may all be substantially equal to a value obtained by subtracting the second low power supply voltage VSS2 from the high power supply voltage VDD. In this case, since the driving voltage VLED1 of the first light-emitting element LED1 is lower than the driving voltage VLED2 of the second light-emitting element LED2 and the driving voltage VLED3 of the third light-emitting element LED3, the drain-source voltage VDS1 of the first transistor T1 of the first sub-pixel SP1 may be higher than the drain-source voltage VDS2 of the first transistor T1 of the second sub-pixel SP2 and the drain-source voltage VDS3 of the first transistor T1 of the third sub-pixel SP3, and accordingly, power consumption of the first sub-pixel SP1 may unnecessarily increase due to the increase in power consumption of the first transistor T1 of the first sub-pixel SP1.

In the present embodiment, the sum of the drain-source voltage VDS1 of the first transistor T1 of the first sub-pixel SP1 and the driving voltage VLED1 of the first light-emitting element LED1 may be substantially equal to a value obtained by subtracting the first low power supply voltage VSS1 from the high power supply voltage VDD, the sum of the drain-source voltage VDS2 of the first transistor T1 of the second sub-pixel SP2 and the driving voltage VLED2 of the second light-emitting element LED2 may be substantially equal to a value obtained by subtracting the second low power supply voltage VSS2 from the high power supply voltage VDD, and the sum of the drain-source voltage VDS3 of the first transistor T1 of the third sub-pixel SP3 and the driving voltage VLED3 of the third light-emitting element LED3 may be substantially equal to the value obtained by subtracting the second low power supply voltage VSS2 from the high power supply voltage VDD. Since the first low power supply voltage VSS1 is higher than the second low power supply voltage VSS2, the drain-source voltage VDS1 of the first transistor T1 of the first sub-pixel SP1 may decrease, and thus, the power consumption of the first sub-pixel SP1 may be effectively reduced. Accordingly, power consumption of the pixel PX may be effectively reduced, and power consumption of the display device 100 may be effectively reduced.

In an embodiment, a voltage difference VDFF between the first low power supply voltage VSS1 and the second low power supply voltage VSS2 may be greater than or equal to about 0.1 V and less than or equal to about 2.0 V. In other words, a value obtained by subtracting the second low power supply voltage VSS2 from the first low power supply voltage VSS1 may be greater than or equal to about 0.1 V and less than or equal to about 2.0 V.

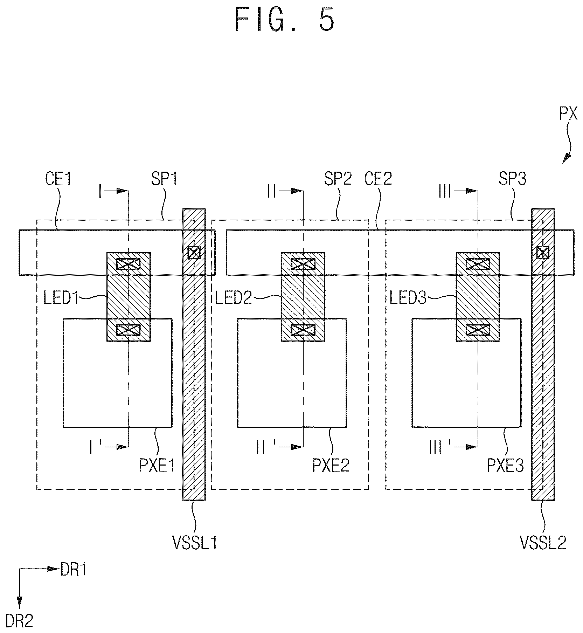

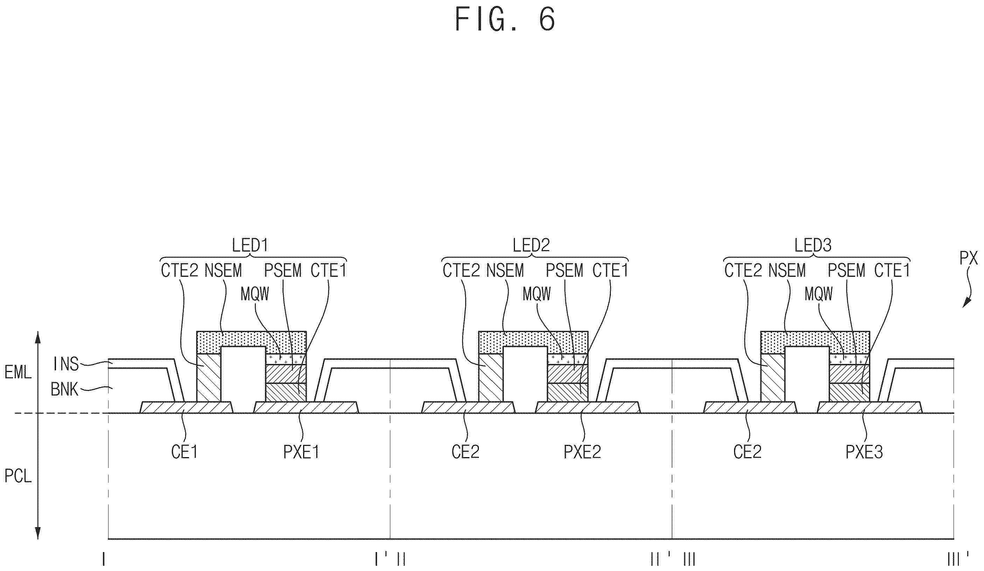

FIG. 5 is a plan view illustrating the pixel PX of FIG. 2. FIG. 6 is a cross-sectional view taken along a line I-I', a line II-II', and a line III-III' of FIG. 5.

Referring to FIGS. 2, 5, and 6, the pixel PX may include a pixel circuit layer PCL and a light-emitting element layer EML.

The pixel circuit layer PCL may include the first to eighth transistors T1, T2, T3, T4, T5, T6, T7, and T8, the first and second capacitors C1 and C2, and lines including the first low voltage power supply line VSSL1 and the second low voltage power supply line VSSL2. The pixel circuit layer PCL may include a substrate, semiconductor layers, conductive layers, and insulating layers disposed between the substrate, semiconductor layers, and conductive layers.

The light-emitting element layer EML may be arranged on the pixel circuit layer PCL. The light-emitting element layer EML may include a first anode electrode PXE1, a second anode electrode PXE2, a third anode electrode PXE3, a first cathode electrode CE1, a second cathode electrode CE2, the first light-emitting element LED1, the second light-emitting element LED2, and the third light-emitting element LED3.

The first anode electrode PXE1, the second anode electrode PXE2, the third anode electrode PXE3, the first cathode electrode CE1, and the second cathode electrode CE2 may be arranged on the pixel circuit layer PCL. The first anode electrode PXE1 may be connected to the fourth node N4 of the first sub-pixel SP1, the second anode electrode PXE2 may be connected to the fourth node N4 of the second sub-pixel SP2, and the third anode electrode PXE3 may be connected to the fourth node N4 of the third sub-pixel SP3. The first cathode electrode CE1 may be connected to the first low voltage power supply line VSSL1, and the second cathode electrode CE2 may be connected to the second low voltage power supply line VSSL2. Accordingly, the first low power supply voltage VSS1 may be applied to the first cathode electrode CE1, and the second low power supply voltage VSS2 may be applied to the second cathode electrode CE2.

Each of the first anode electrode PXE1, the second anode electrode PXE2, the third anode electrode PXE3, the first cathode electrode CE1, and the second cathode electrode CE2 may include a metal, a transparent conductive oxide, or the like. In an embodiment, each of the first anode electrode PXE1, the second anode electrode PXE2, the third anode electrode PXE3, the first cathode electrode CE1, and the second cathode electrode CE2 may have a laminated structure of aluminum and titanium (Ti/Al/Ti), a laminated structure of aluminum and ITO (ITO/AI/ITO), an APC alloy, or a laminated structure of an APC alloy and ITO (ITO/APC/ITO). The APC alloy may be an alloy of silver (Ag), palladium (Pd), and copper (Cu).

Each of the first light-emitting element LED1, the second light-emitting element LED2, and the third light-emitting element LED3 may include an inorganic material such as GaN. Each of the first light-emitting element LED1, the second light-emitting element LED2, and the third light-emitting element LED3 may include an active layer MQW, an N-type semiconductor NSEM, a P-type semiconductor PSEM, a first electrode CTE1, and a second electrode CTE2.

The active layer MQW may be arranged between the N-type semiconductor NSEM and the P-type semiconductor PSEM. The active layer MQW may include a material having a single or multiple quantum well structure. When the active layer MQW includes a material having the multiple quantum well structure, the active layer MQW may have a structure in which a plurality of well layers and barrier layers are alternately laminated. In this case, the well layer may include InGaN, and the barrier layer may include GaN or AlGaN. The active layer MQW may have a structure in which semiconductor materials having large band gap energy and semiconductor materials having small band gap energy are alternately laminated, and may include other group III to group V semiconductor materials depending on a wavelength of emitted light.

The N-type semiconductor NSEM may be arranged between the active layer MQW and the second electrode CTE2. For example, the N-type semiconductor NSEM may be formed of GaN doped with an N-type conductive dopant such as Si, Ge, or Sn.

The P-type semiconductor PSEM may be arranged between the active layer MQW and the first electrode CTE1. For example, the P-type semiconductor PSEM may be formed of GaN doped with a P-type conductive dopant such as Mg, Zn, Ca, Se, or Ba.

The first electrode CTE1 may be arranged between the P-type semiconductor PSEM and the anode electrode PXE1, PXE2, and PXE3. The second electrode CTE2 may be arranged between the N-type semiconductor NSEM and the cathode electrode CE1 and CE2.

A bank BNK covering edges of the anode electrodes PXE1, PXE2, and PXE3 and edges of the cathode electrodes CE1 and CE2 may be arranged on the pixel circuit layer PCL. The bank BNK may include an organic material such as an acrylic resin, an epoxy resin, a phenolic resin, a polyamide resin, a polyimide resin, or the like.

An insulating layer INS may be arranged on the bank BNK. The insulating layer INS may cover the edges of the anode electrodes PXE1, PXE2, and PXE3 and the edges of the cathode electrodes CE1 and CE2. The insulating layer INS may include an inorganic material such as silicon nitride, silicon oxynitride, silicon oxide, titanium oxide, aluminum oxide, etc.

In an embodiment, the first cathode electrode CE1 and the second cathode electrode CE2 may extend in a first direction DR1, and the first low voltage power supply line VSSL1 and the second low voltage power supply line VSSL2 may extend in a second direction DR2 intersecting the first direction DR1. The first cathode electrode CE1 may be connected to the first low voltage power supply line VSSL1 through a contact hole formed in an area in which the first cathode electrode CE1 and the first low voltage power supply line VSSL1 intersect, and the second cathode electrode CE2 may be connected to the second low voltage power supply line VSSL2 through a contact hole formed in an area in which the second cathode electrode CE2 and the second low voltage power supply line VSSL2 intersect.

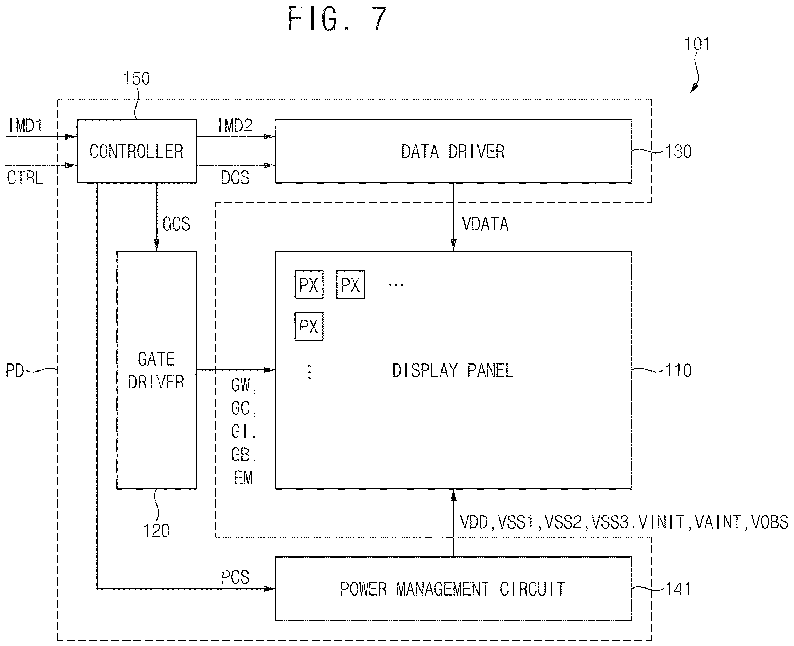

FIG. 7 is a block diagram illustrating a display device 101 according to an embodiment.

Referring to FIG. 7, the display device 101 may include a display panel 110 and a panel driver PD. The panel driver PD may include a gate driver 120, a data driver 130, a power management circuit 141, and a controller 150. Descriptions of components of the display device 101 described with reference to FIG. 7, which are substantially the same as or similar to those of the display device 100 described with reference to FIG. 1, are omitted.

The power management circuit 141 may provide the high power supply voltage VDD, the first low power supply voltage VSS1, the second low power supply voltage VSS2, a third low power supply voltage VSS3, the first initialization voltage VINIT, the second initialization voltage VAINT, and the bias voltage VOBS to the pixels PX. The power management circuit 140 may generate the high power supply voltage VDD, the first low power supply voltage VSS1, the second low power supply voltage VSS2, the third low power supply voltage VSS3, the first initialization voltage VINIT, the second initialization voltage VAINT, and the bias voltage VOBS based on the power control signal PCS.

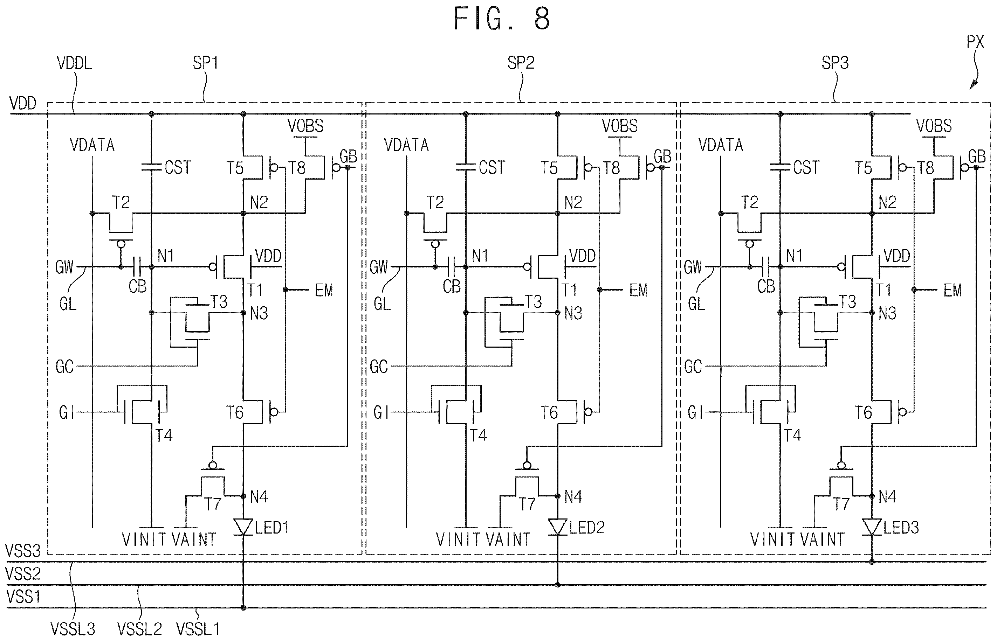

FIG. 8 is a circuit diagram illustrating the pixel PX of FIG. 7.

Referring to FIGS. 7 and 8, the pixel PX may include a first sub-pixel SP1, a second sub-pixel SP2, and a third sub-pixel SP3. Descriptions of components of the pixel PX described with reference to FIG. 8, which are substantially the same as or similar to those of the pixel PX described with reference to FIG. 2, are omitted.

The third sub-pixel SP3 may include the third light-emitting element LED3. The third light-emitting element LED3 may be connected between the high voltage power supply line VDDL and a third low voltage power supply line VSSL3 that transmits the third low power supply voltage VSS3. The third light-emitting element LED3 may include a first terminal connected to the fourth node N4 of the third sub-pixel SP3 and a second terminal connected to the third low voltage power supply line VSSL3. The second low power supply voltage VSS2 may be higher than the third low power supply voltage VSS3. For example, the second low power supply voltage VSS2 may be about 0.3 V, and the third low power supply voltage VSS3 may be about 0 V.

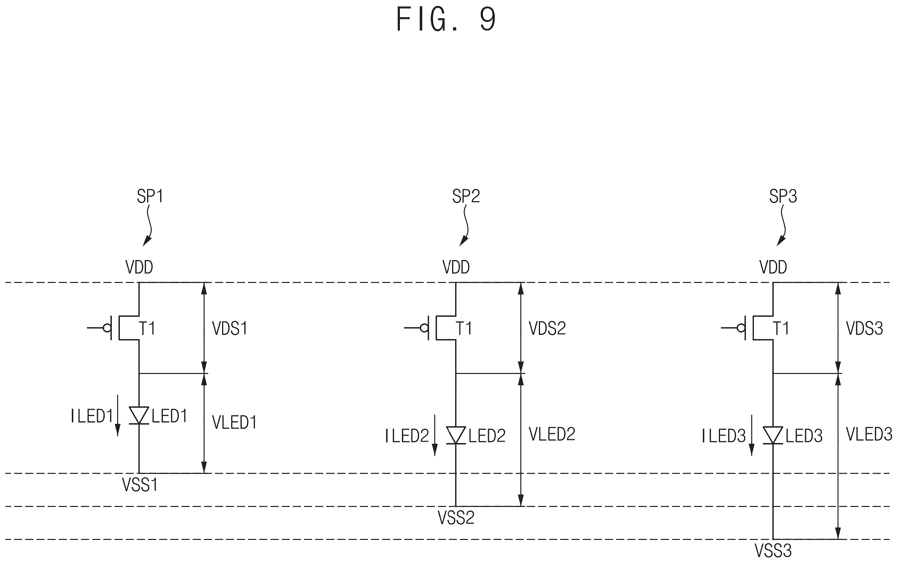

FIG. 9 is a diagram for describing voltages VLED1, VLED2, and VLED3 of the sub-pixels SP1, SP2, and SP3 of FIG. 8.

Referring to FIGS. 8 and 9, the sum of the drain-source voltage VDS1 of the first transistor T1 of the first sub-pixel SP1 and the driving voltage VLED1 of the first light-emitting element LED1 may be substantially equal to the value obtained by subtracting the first low power supply voltage VSS1 from the high power supply voltage VDD, the sum of the drain-source voltage VDS2 of the first transistor T1 of the second sub-pixel SP2 and the driving voltage VLED2 of the second light-emitting element LED2 may be substantially equal to the value obtained by subtracting the second low power supply voltage VSS2 from the high power supply voltage VDD, and the sum of the drain-source voltage VDS3 of the first transistor T1 of the third sub-pixel SP3 and the driving voltage VLED3 of the third light-emitting element LED3 may be substantially equal to a value obtained by subtracting the third low power supply voltage VSS3 from the high power supply voltage VDD. Since the first low power supply voltage VSS1 is higher than the second low power supply voltage VSS2 and the third low power supply voltage VSS3, the drain-source voltage VDS1 of the first transistor T1 of the first sub-pixel SP1 may decrease, and thus, the power consumption of the first sub-pixel SP1 may be effectively reduced. Further, since the second low power supply voltage VSS2 is higher than the third low power supply voltage VSS3, the drain-source voltage VDS2 of the first transistor T1 of the second sub-pixel SP2 may decrease, and thus, the power consumption of the second sub-pixel SP2 may be effectively reduced. Accordingly, the power consumption of the pixel PX may be effectively reduced, and the power consumption of the display device 101 may be effectively reduced.

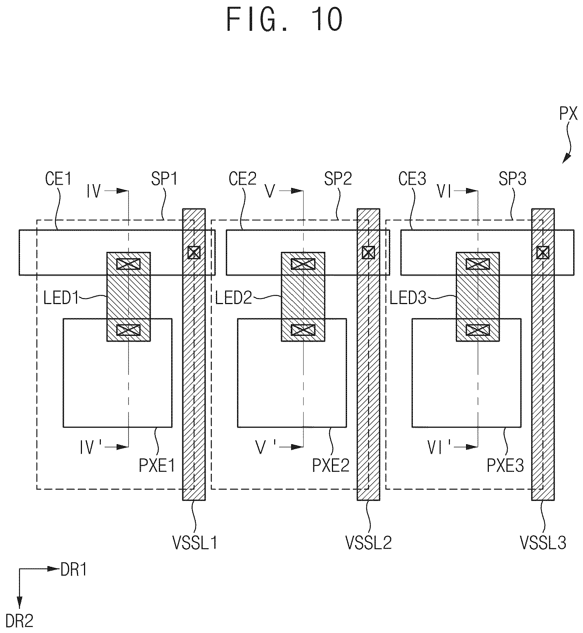

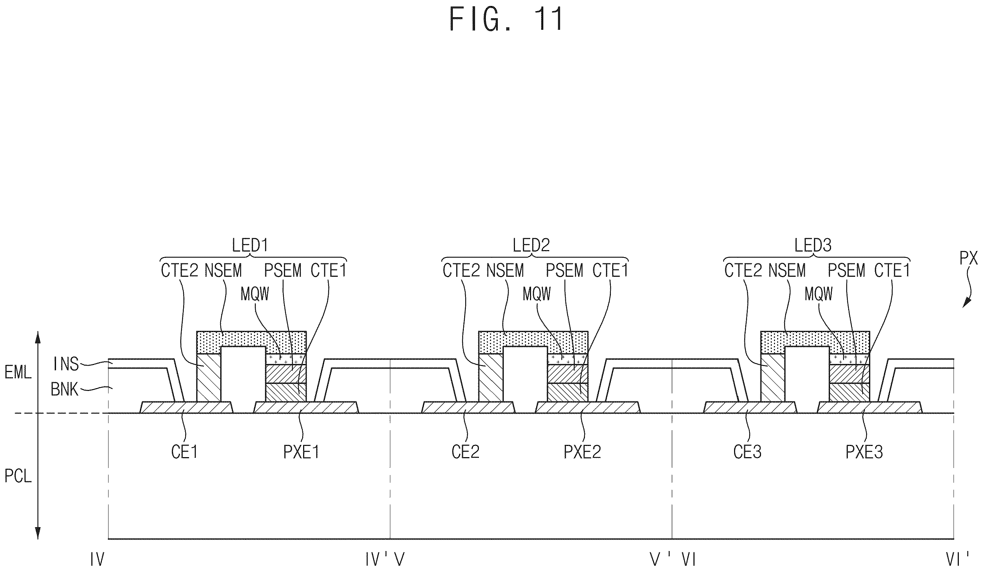

FIG. 10 is a plan view illustrating the pixel PX of FIG. 8. FIG. 11 is a cross-sectional view taken along a line IV-IV', a line V-V', and a line VI-VI' of FIG. 10.

Referring to FIGS. 8, 10, and 11, the pixel PX may include a pixel circuit layer PCL and a light-emitting element layer EML. Descriptions of components of the pixel PX described with reference to FIGS. 10 and 11, which are substantially the same as or similar to those of the pixel PX described with reference to FIGS. 5 and 6, are omitted.

The light-emitting element layer EML may be arranged on the pixel circuit layer PCL. The light-emitting element layer EML may include the first anode electrode PXE1, the second anode electrode PXE2, the third anode electrode PXE3, the first cathode electrode CE1, the second cathode electrode CE2, a third cathode electrode CE3, the first light-emitting element LED1, the second light-emitting element LED2, and the third light-emitting element LED3.

The first anode electrode PXE1, the second anode electrode PXE2, the third anode electrode PXE3, the first cathode electrode CE1, the second cathode electrode CE2, and the third cathode electrode CE3 may be arranged on the pixel circuit layer PCL. The first cathode electrode CE1 may be connected to the first low voltage power supply line VSSL1, the second cathode electrode CE2 may be connected to the second low voltage power supply line VSSL2, and the third cathode electrode CE3 may be connected to the third low voltage power supply line VSSL3. Accordingly, the first low power supply voltage VSS1 may be applied to the first cathode electrode CE1, the second low power supply voltage VSS2 may be applied to the second cathode electrode CE2, and the third low power supply voltage VSS3 may be applied to the third cathode electrode CE3.

In an embodiment, the first cathode electrode CE1, the second cathode electrode CE2, and the third cathode electrode CE3 may extend in a first direction DR1, and the first low voltage power supply line VSSL1, the second low voltage power supply line VSSL2, and the third low voltage power supply line VSSL3 may extend in a second direction DR2 intersecting the first direction DR1. The first cathode electrode CE1 may be connected to the first low voltage power supply line VSSL1 through a contact hole formed in an area in which the first cathode electrode CE1 and the first low voltage power supply line VSSL1 intersect, the second cathode electrode CE2 may be connected to the second low voltage power supply line VSSL2 through a contact hole formed in an area in which the second cathode electrode CE2 and the second low voltage power supply line VSSL2 intersect, and the third cathode electrode CE3 may be connected to the third low voltage power supply line VSSL3 through a contact hole formed in an area in which the third cathode electrode CE3 and the third low voltage power supply line VSSL3 intersect.

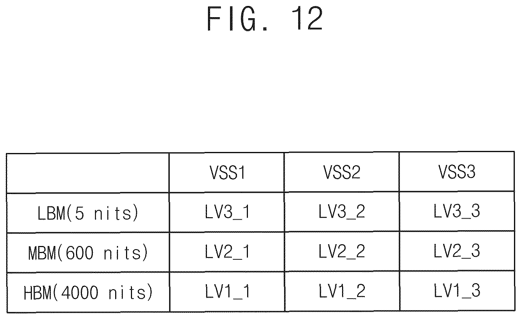

FIG. 12 is a table illustrating the first to third low power supply voltages VSS1, VSS2, and VSS3 in brightness modes LBM, MBM, and HBM.

Referring to FIGS. 7 and 12, the display device 101 may control voltage levels of the first to third low power supply voltages VSS1, VSS2, and VSS3 according to the brightness modes LBM, MBM, and HBM. The controller 150 may generate the power control signal PCS based on the brightness modes LBM, MBM, and HBM, and the power management circuit 141 may control the voltage levels of the first to third low power supply voltages VSS1, VSS2, and VSS3 based on the power control signal PCS.

The brightness modes LBM, MBM, and HBM may include a low brightness mode LBM, a medium brightness mode MBM, and a high brightness mode HBM. The display device 101 may change the brightness modes LBM, MBM, and HBM according to external illumination. The display device 101 may operate in the low brightness mode LBM in a dark indoor environment, and may operate in the high brightness mode HBM in a bright outdoor environment.

A luminance level of the display device 101 in the low brightness mode LBM may be lower than a luminance level of the display device 101 in the medium brightness mode MBM, and a luminance level of the display device 101 in the high brightness mode HBM may be higher than the luminance level of the display device 101 in the medium brightness mode MBM. For example, a maximum luminance of the display device 101 in the low brightness mode LBM may be about 5 nits, a maximum luminance of the display device 101 in the medium brightness mode MBM may be about 600 nits, and a maximum luminance of the display device 101 in the high brightness mode HBM may be about 4000 nits.

A voltage level LV3_1 of the first low power supply voltage VSS1, a voltage level LV3_2 of the second low power supply voltage VSS2, and a voltage level LV3_3 of the third low power supply voltage VSS3 in the low brightness mode LBM may be higher than a voltage level LV2_1 of the first low power supply voltage VSS1, a voltage level LV2_2 of the second low power supply voltage VSS2, and a voltage level LV2_3 of the third low power supply voltage VSS3 in the medium brightness mode MBM, respectively. Since the driving voltage of the light-emitting element in the low brightness mode LBM is lower than the driving voltage of the light-emitting element in the medium brightness mode MBM, the voltage levels LV3_1, LV3_2, LV3_3 of the low power supply voltages VSS1, VSS2, and VSS3 in the low brightness mode LBM may be higher than the voltage levels LV2_1, LV2_2, LV2_3 of the low power supply voltages VSS1, VSS2, and VSS3 in the medium brightness mode MBM, and accordingly, the power consumption of the display device 101 may be effectively reduced.

A voltage level LV1_1 of the first low power supply voltage VSS1, a voltage level LV1_2 of the second low power supply voltage VSS2, and a voltage level LV1_3 of the third low power supply voltage VSS3 in the high brightness mode HBM may be lower than the voltage level LV2_1 of the first low power supply voltage VSS1, the voltage level LV2_2 of the second low power supply voltage VSS2, and the voltage level LV2_3 of the third low power supply voltage VSS3 in the medium brightness mode MBM, respectively. Since the driving voltage of the light-emitting element in the high-brightness mode HBM is higher than the driving voltage of the light-emitting element in the medium-brightness mode MBM, the voltage levels LV1_1, LV1_2, LV1_3 of the low power supply voltages VSS1, VSS2, and VSS3 in the high-brightness mode HBM may be lower than the voltage levels LV2_1, LV2_2, LV2_3 of the low power supply voltages VSS1, VSS2, and VSS3 in the medium-brightness mode MBM, and accordingly, the display device 101 may display an image with high luminance.

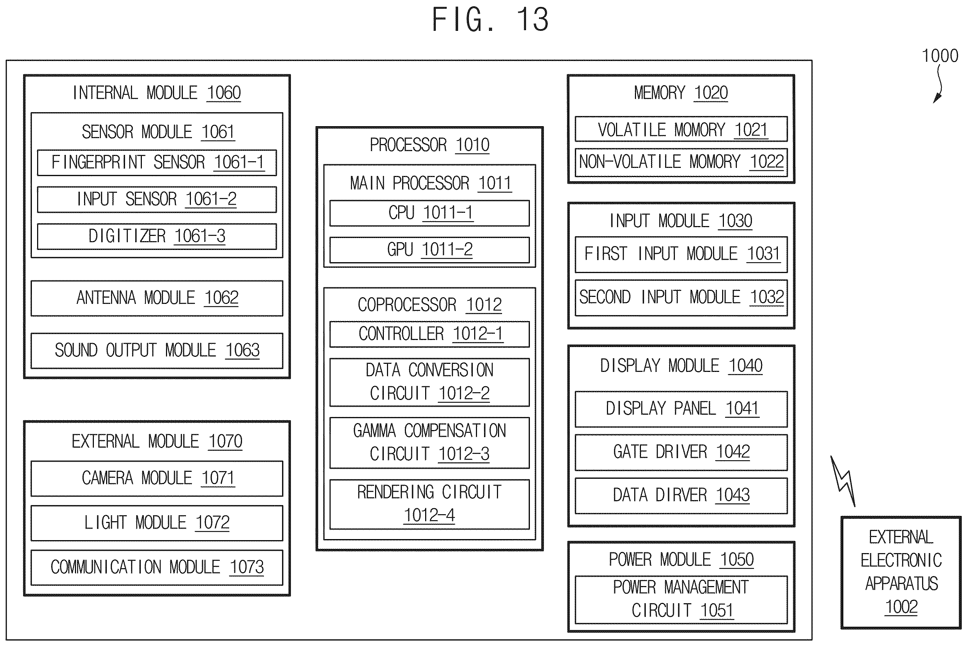

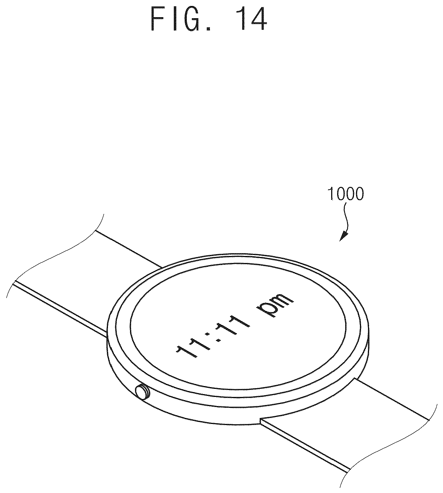

FIG. 13 is a block diagram illustrating an electronic apparatus 1000 according to an embodiment. FIG. 14 is a diagram illustrating an example in which the electronic apparatus 1000 of FIG. 13 is implemented as a smart watch.

Referring to FIGS. 13 and 14, the electronic apparatus 1000 may output various information through a display module 1040 within operating system. When a processor 1010 executes an application stored in a memory 1020, the display module 1040 may provide application information to a user through a display panel 1041. In other words, the processor 1010 may control the display module 1040. In an embodiment, the processor 1010 may provide the input image data IMD1 of FIGS. 1 and 7 and the control signal CTRL of FIGS. 1 and 7 to the display module 1040.

In an embodiment, as illustrated in FIG. 14, the electronic apparatus 1000 may be implemented as a smart watch. However, the present disclosure is not limited thereto, and in other embodiments, the electronic apparatus 1000 may be implemented as a television, a mobile phone, a video phone, a smart pad, a computer monitor, a tablet PC, a vehicle navigation system, a notebook, a head-mounted display device, etc.

The processor 1010 may obtain an external input through an input module 1030 or a sensor module 1061, and may execute an application corresponding to the external input. For example, when the user selects a camera icon displayed on the display panel 1041, the processor 1010 may obtain a user input through an input sensor 1061-2, and may activate a camera module 1071. The processor 1010 may transmit image data corresponding to a captured image acquired through the camera module 1071 to the display module 1040. The display module 1040 may display an image corresponding to the captured image through the display panel 1041. Some of components of the electronic apparatus 1000 may be integrated and provided as one component, or one component may be provided separately into two or more components.

The electronic apparatus 1000 may communicate with an external electronic apparatus 1002 through a network (e.g., a short-range wireless communication network or a long-range wireless communication network). In an embodiment, the electronic apparatus 1000 may include the processor 1010, the memory 1020, the input module 1030, the display module 1040, a power module 1050, an internal module 1060, and an external module 1070. In an embodiment, the electronic apparatus 1000 may omit at least one of the above-described components, or one or more other components may be added. In an embodiment, some of the above-described components (e.g., a sensor module 1061, an antenna module 1062, or a sound output module 1063) may be integrated into another component (e.g., the display module 1040).

The processor 1010 may execute software to control at least one other component (e.g., hardware or software component) of the electronic apparatus 1000 connected to the processor 1010, and may perform various data processing or calculation. In an embodiment, as at least part of data processing or calculation, the processor 1010 may store commands or data received from another component (e.g., the input module 1030, the sensor module 1061, or a communication module 1073) in a volatile memory 1021, may process the commands or data stored in the volatile memory 1021, and may store resultant data in a non-volatile memory 1022.

The processor 1010 may include a main processor 1011 and a coprocessor 1012. The main processor 1011 may include one or more of a central processing unit (CPU) 1011-1 or an application processor (AP). The main processor 1011 may further include one or more of a graphics processing unit (GPU) 1011-2, a communication processor (CP), and an image signal processor (ISP). At least two of the above-described processing unit and processor may be implemented as an integrated component (e.g., a single chip), or each may be implemented as an independent component (e.g., a plurality of chips).

The coprocessor 1012 may include a controller 1012-1. The controller 1012-1 may include an interface conversion circuit and a timing control circuit. The controller 1012-1 may receive an image signal from the main processor 1011, may convert data format of the image signal to suit the interface specifications with the display module 1040, and may output image data. The controller 1012-1 may output various control signals for driving the display module 1040.

The coprocessor 1012 may further include a data conversion circuit 1012-2, a gamma correction circuit 1012-3, a rendering circuit 1012-4, etc. The data conversion circuit 1012-2 may receive the image data from the controller 1012-1, and may compensate the image data such that the image is displayed at a desired luminance according to the characteristics of the electronic apparatus 1000 or the user's settings or may convert the image data to reduce power consumption or compensate for afterimages. The gamma correction circuit 1012-3 may convert the image data or a gamma reference voltage such that an image displayed on the electronic apparatus 1000 has desired gamma characteristics. The rendering circuit 1012-4 may receive the image data from the controller 1012-1, and may render the image data by considering a pixel arrangement of the display panel 1041 applied to the electronic apparatus 1000. At least one of the data conversion circuit 1012-2, the gamma correction circuit 1012-3, and the rendering circuit 1012-4 may be integrated into another component (e.g., the main processor 1011 or a controller). At least one of the data conversion circuit 1012-2, the gamma correction circuit 1012-3, and the rendering circuit 1012-4 may be integrated into a data driver 1043 to be described below.

The memory 1020 may store various data used by at least one component of the electronic apparatus 1000 (e.g., the processor 1010 or the sensor module 1061) and input data or output data for commands related thereto. The memory 1020 may include at least one of the volatile memory 1021 and the non-volatile memory 1022.

The input module 1030 may receive commands or data to be used in components of the electronic apparatus 1000 (e.g., the processor 1010, the sensor module 1061, or the sound output module 1063) from the outside of the electronic apparatus 1000 (e.g., the user or the external electronic apparatus 1002).

The input module 1030 may include a first input module 1031 through which commands or data are input from the user, and a second input module 1032 through which command or data are input from the external electronic apparatus 1002. The first input module 1031 may include a microphone, a mouse, a keyboard, a key (e.g., button), or a pen (e.g., passive pen or active pen). The second input module 1032 may support a designated protocol that may connect to the external electronic apparatus 1002 by wire or wirelessly. In an embodiment, the second input module 1032 may include a high definition multimedia interface (HDMI), a universal serial bus (USB) interface, an SD card interface, or an audio interface. The second input module 1032 may include a connector that may be physically connected to the external electronic apparatus 1002, for example, an HDMI connector, a USB connector, an SD card connector, or an audio connector (e.g., a headphone connector).

The display module 1040 may provide visual information to the user. The display module 1040 may include the display panel 1041, a gate driver 1042, and the data driver 1043. The display module 1040 may further include a window, a chassis, and a bracket to protect the display panel 1041. The display module 1040 may correspond to the display device 100 of FIG. 1 and the display device 101 of FIG. 7. The display panel 1041, the gate driver 1042, and the data driver 1043 may correspond to the display panel 110, the gate driver 120, and the data driver 130 of FIGS. 1 and 7.

The power module 1050 may supply power to components of the electronic apparatus 1000. The power module 1050 may include a battery that charges power supply voltage. The battery may include a non-rechargeable primary cell, a rechargeable secondary cell, or a fuel cell. The power module 1050 may include a power management circuit 1051. The power management circuit 1051 may supply optimized power to each of the above-described modules and the modules described below. The power management circuit 1051 may correspond to the power management circuit 140 of FIG. 1 and the power management circuit 141 of FIG. 7. The power module 1050 may include a wireless power transmission/reception member electrically connected to the battery. The wireless power transmission/reception member may include a plurality of coil-shaped antenna radiators.

The electronic apparatus 1000 may further include the internal module 1060 and the external module 1070. The internal module 1060 may include the sensor module 1061, the antenna module 1062, and the sound output module 1063. The external module 1070 may include the camera module 1071, a light module 1072, and a communication module 1073.

The sensor module 1061 may detect an input by the user's body or an input by the pen among the first input module 1031, and may generate an electrical signal or a data value corresponding to the input. The sensor module 1061 may include at least one of a fingerprint sensor 1061-1, an input sensor 1061-2, and a digitizer 1061-3.

The processor 1010 may output commands or data to the display module 1040, the sound output module 1063, the camera module 1071, or the light module 1072 based on the input data received from the input module 1030. For example, the processor 1010 may generate image data in response to input data applied through the mouse or the active pen and output the image data to the display module 1040, or may generate command data in response to the input data to output the command data to the camera module 1071 or the light module 1072. When no input data is received from the input module 1030 for a certain period of time, the processor 1010 may switch an operation mode of the electronic apparatus 1000 to a low power mode or a sleep mode to reduce power consumption of the electronic apparatus 1000.

The processor 1010 may output commands or data to the display module 1040, the sound output module 1063, the camera module 1071, or the light module 1072 based on sensing data received from the sensor module 1061. For example, the processor 1010 may compare authentication data authorized by the fingerprint sensor 1061-1 with authentication data stored in the memory 1020, and then may execute an application according to the comparison result. The processor 1010 may execute command or output corresponding image data to the display module 1040 based on sensing data detected by the input sensor 1061-2 or the digitizer 1061-3. When the sensor module 1061 includes a temperature sensor, the processor 1010 may receive temperature data for a temperature measured from the sensor module 1061, and may further perform luminance correction for the image data or the like based on the temperature data.

The display device according to the embodiments may be applied to a display device included in a computer, a notebook, a mobile phone, a smart phone, a smart pad, a smart watch, a PMP, a PDA, an MP3 player, or the like.

Although the pixel, the display device, and the electronic apparatus according to the embodiments have been described with reference to the drawings, the illustrated embodiments are examples, and may be modified and changed by a person having ordinary knowledge in the relevant technical field without departing from the scope of the invention as set out in the following claims.

## Claims

1. A pixel comprising:
a first sub-pixel comprising a first light-emitting element connected between a high voltage power supply line, which transmits a high power supply voltage, and a first low voltage power supply line, which transmits a first low power supply voltage lower than the high power supply voltage; and
a second sub-pixel comprising a second light-emitting element connected between the high voltage power supply line and a second low voltage power supply line, which transmits a second low power supply voltage lower than the high power supply voltage,
wherein the first low power supply voltage is higher than the second low power supply voltage.

2. The pixel of claim 1, further comprising:
a third sub-pixel comprising a third light-emitting element connected between the high voltage power supply line and the second low voltage power supply line.

3. The pixel of claim 2, wherein the first light-emitting element emits red light, the second light-emitting element emits green light, and the third light-emitting element emits blue light.

4. The pixel of claim 2 or 3, wherein a turn-on voltage of the first light-emitting element is lower than a turn-on voltage of the second light-emitting element, and
wherein the turn-on voltage of the second light-emitting element is lower than a turn-on voltage of the third light-emitting element.

5. The pixel of claim 2, 3 or 4, wherein a first cathode electrode connected to a second electrode of the first light-emitting element and a second cathode electrode connected to both a second electrode of the second light-emitting element and a second electrode of the third light-emitting element extend in a first direction, and
wherein the first low voltage power supply line, which is connected to the first cathode electrode, and the second low voltage power supply line, which is connected to the second cathode electrode, extend in a second direction intersecting the first direction.

6. The pixel of claim 1, further comprising:
a third sub-pixel comprising a third light-emitting element connected between the high voltage power supply line and a third low voltage power supply line, which transmits a third low power supply voltage lower than the high power supply voltage,
wherein the second low power supply voltage is higher than the third low power supply voltage.

7. The pixel of claim 6, wherein a first cathode electrode connected to a second electrode of the first light-emitting element, a second cathode electrode connected to a second electrode of the second light-emitting element, and a third cathode electrode connected a second electrode of the third light-emitting element, extend in a first direction, and
wherein the first low voltage power supply line, which is connected to the first cathode electrode, the second low voltage power supply line, which is connected to the second cathode electrode, and the third low voltage power supply line, which is connected to the third cathode electrode, extend in a second direction intersecting the first direction.

8. The pixel of any one of the preceding claims, wherein a voltage difference between the first low power supply voltage and the second low power supply voltage is greater than or equal to 0.1V and less than or equal to 2.0V.

9. The pixel of any one of the preceding claims, wherein each of the first light-emitting element and the second light-emitting element is a micro light-emitting diode.

10. The pixel of any one of the preceding claims, wherein each of the first sub-pixel and the second sub-pixel further comprises:
a first transistor comprising a gate connected to a first node, a first terminal connected to a second node, and a second terminal connected to a third node;
a second transistor, which transmits a data voltage to the second node in response to a first gate signal;
a third transistor, which connects the first node to the third node in response to a second gate signal;
a fourth transistor, which transmits a first initialization voltage to the first node in response to a third gate signal;
a fifth transistor, which transmits the high power supply voltage to the second node in response to an emission signal;
a sixth transistor, which connects the third node to a fourth node connected to a first electrode of a corresponding light-emitting element among the first light-emitting element and the second light-emitting element in response to the emission signal;
a seventh transistor, which transmits a second initialization voltage to the fourth node in response to a fourth gate signal; and
a first capacitor connected between the high voltage power supply line and the first node and wherein each of the first sub-pixel and the second sub-pixel optionally further comprises:
an eighth transistor, which transmits a bias voltage to the second node in response to the fourth gate signal.

11. The pixel of claim 10, wherein each of the first sub-pixel and the second sub-pixel further comprises:
a second capacitor connected between a gate line, which transmits the first gate signal and the first node.

12. The pixel of any one of the preceding claims, wherein a voltage level of the first low power supply voltage in a low brightness mode is higher than a voltage level of the first low power supply voltage in a medium brightness mode having a luminance level higher than a luminance level of the low luminance mode, and
wherein a voltage level of the second low power supply voltage in the low brightness mode is higher than a voltage level of the second low power supply voltage in the medium brightness mode.

13. The pixel of claim 12, wherein a voltage level of the first low power supply voltage in a high brightness mode having a luminance level higher than the luminance level of the medium luminance mode is lower than the voltage level of the first low power supply voltage in the medium brightness mode, and
wherein a voltage level of the second low power supply voltage in the high brightness mode is lower than the voltage level of the second low power supply voltage in the medium brightness mode.

14. A display device comprising:
a display panel comprising a pixel according to any one of the preceding claims; and
a panel driver, which provides the high power supply voltage, the first low power supply voltage, and the second low power supply voltage to the pixel.

15. An electronic apparatus comprising:
a display device according to claim 14; and
a processor configured to control the display device.

## Amended claims

### Amended claims in accordance with Rule 137(2) EPC.

1. A display device (100) comprising:
a display panel (110) comprising a pixel (PX); and
a panel driver (PD), which provides a high power supply voltage (VDD), a first low power supply voltage (VSS1), and a second low power supply voltage (VSS2) to the pixel;
wherein the pixel (PX) comprises:
a first sub-pixel (SP1) comprising a first light-emitting element (LED1) connected between a high voltage power supply line (VDDL), which transmits the high power supply voltage (VDD), and a first low voltage power supply line (VSSL1), which transmits the first low power supply voltage (VSS1) lower than the high power supply voltage (VDD); and
a second sub-pixel (SP2) comprising a second light-emitting element (LED2) connected between the high voltage power supply line (VDDL) and a second low voltage power supply line (VSSL2), which transmits the second low power supply voltage (VSS2) lower than the high power supply voltage (VDD),
wherein the first low power supply voltage (VSS1) is higher than the second low power supply voltage (VSS2);
**characterised in that**:
the pixel (PX) further comprises: a third sub-pixel (SP3) comprising a third light-emitting element (LED3) connected between the high voltage power supply line (VDDL) and the second low voltage power supply line (VSSL2); and
a first cathode electrode (CE1) connected to a second electrode of the first light-emitting element (LED1) and a second cathode electrode (CE2) connected to both a second electrode of the second light-emitting element (LED2) and a second electrode of the third light-emitting element (LED3) extend in a first direction (DR1), and
wherein the first low voltage power supply line (VSSL1), which is connected to the first cathode electrode, and the second low voltage power supply line (VSSL2), which is connected to the second cathode electrode, extend in a second direction (DR2) intersecting the first direction.

2. The display device of claim 1, wherein the first light-emitting element (LED1) emits red light, the second light-emitting element (LED2) emits green light, and the third light-emitting element (LED3) emits blue light.

3. The display device of claim 1 or 2, wherein a turn-on voltage of the first light-emitting element (VF1) is lower than a turn-on voltage of the second light-emitting element (VF2), and
wherein the turn-on voltage of the second light-emitting element (VF2) is lower than a turn-on voltage of the third light-emitting element (VF3).

4. The display device of any one of the preceding claims, wherein a voltage difference (VDFF) between the first low power supply voltage (VSS1) and the second low power supply voltage (VSS2) is greater than or equal to 0.1V and less than or equal to 2.0V.

5. The display device of any one of the preceding claims, wherein each of the first light-emitting element (LED1) and the second light-emitting element (LED2) is a micro light-emitting diode.

6. The display device of any one of the preceding claims, wherein each of the first sub-pixel (SP1) and the second sub-pixel (SP2) further comprises:
a first transistor (T1) comprising a gate connected to a first node (N1), a first terminal connected to a second node (N2), and a second terminal connected to a third node (N3);
a second transistor (T2), which transmits a data voltage (VDATA) to the second node (N2) in response to a first gate signal (GW);
a third transistor (T3), which connects the first node (N1) to the third node (N3) in response to a second gate signal (GC);
a fourth transistor (T4), which transmits a first initialization voltage (VINIT) to the first node (N1) in response to a third gate signal (GI);
a fifth transistor (T5), which transmits the high power supply voltage (VDD) to the second node (N2) in response to an emission signal (EM);
a sixth transistor (T6), which connects the third node (N3) to a fourth node (N4) connected to a first electrode of a corresponding light-emitting element among the first light-emitting element (LED1) and the second light-emitting element (LED2) in response to the emission signal (EM);
a seventh transistor (T7), which transmits a second initialization voltage (VAINT) to the fourth node (N4) in response to a fourth gate signal (GB); and
a first capacitor (CST) connected between the high voltage power supply line (VDDL) and the first node (N1) and wherein each of the first sub-pixel (SP1) and the second sub-pixel (SP2) optionally further comprises:
an eighth transistor (T8), which transmits a bias voltage (VOBS) to the second node (N2) in response to the fourth gate signal (GB).

7. The display device of claim 6, wherein each of the first sub-pixel (SP1) and the second sub-pixel (SP2) further comprises:
a second capacitor (CB) connected between a gate line (GL), which transmits the first gate signal (GW) and the first node (N1).

8. The display device of any one of the preceding claims, wherein the panel driver (PD) is configured such that:
a voltage level of the first low power supply voltage (VSS1) in a low brightness mode (LBM) is higher than a voltage level of the first low power supply voltage in a medium brightness mode (MBM) having a luminance level higher than a luminance level of the low brightness mode (LBM), and
a voltage level of the second low power supply voltage (VSS2) in the low brightness mode (LBM) is higher than a voltage level of the second low power supply voltage in the medium brightness mode (MBM).

9. The display device of claim 8, wherein the panel driver (PD) is configured such that:
a voltage level of the first low power supply voltage (VSS1) in a high brightness mode (HBM) having a luminance level higher than the luminance level of the medium luminance mode (MBM) is lower than the voltage level of the first low power supply voltage in the medium brightness mode (MBM), and
a voltage level of the second low power supply voltage (VSS2) in the high brightness mode (HBM) is lower than the voltage level of the second low power supply voltage in the medium brightness mode (MBM).

10. An electronic apparatus (1000) comprising:
a display device according to any preceding claim; and
a processor (1010) configured to control the display device.
